(19) **Europäisches Patentamt / European Patent Office / Office européen des brevets**

(11) **EP 2 486 655 B1**

(12) # FASCICULE DE BREVET EUROPEEN

(45) Date de publication et mention
de la délivrance du brevet:
**07.08.2019 Bulletin 2019/32**

(21) Numéro de dépôt: **10760693.1**

(22) Date de dépôt: **04.10.2010**

(51) Int Cl.:
*H03H 3/007* (2006.01)   *H03H 3/02* (2006.01)
*H03H 3/08* (2006.01)

(86) Numéro de dépôt international:
**PCT/EP2010/064741**

(87) Numéro de publication internationale:
**WO 2011/042388 (14.04.2011 Gazette 2011/15)**

(54) **DISPOSITIF À ONDES ACOUSTIQUES COMPRENANT UN À DE SURFACE ET UN FILTRE À ONDES DE VOLUME ET PROCÉDÉ DE FABRICATION**

**SCHALLWELLENVORRICHTUG MIT EINEM OBERFLÄCHENWELLENFILTER UND EINEM VOLUMENWELLENFILTER SOWIE HERSTELLUNGSVERFAHREN DAFÜR**

**ACOUSTIC WAVE DEVICE INCLUDING A SURFACE WAVE FILTER AND A BULK WAVE FILTER, AND METHOD FOR MAKING SAME**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **09.10.2009 FR 0904845**

(43) Date de publication de la demande:
**15.08.2012 Bulletin 2012/33**

(73) Titulaire: **Commissariat à l'Énergie Atomique et aux Énergies Alternatives
75015 Paris (FR)**

(72) Inventeurs:
• **DEGUET, Chrystel
38330 Saint Ismier (FR)**
• **CLAVELIER, Laurent
38000 Grenoble (FR)**
• **DEFAY, Emmanuel
38340 Voreppe (FR)**
• **REINHARDT, Alexandre
38800 Grenoble (FR)**

(74) Mandataire: **Esselin, Sophie
Marks & Clerk France
Conseils en Propriété Industrielle
Immeuble Visium
22 avenue Aristide Briand
94117 Arcueil Cedex (FR)**

(56) Documents cités:
**EP-A1- 1 764 918        JP-A- 2008 211 393
US-A1- 2008 024 245**

• **J-S MOULET ET AL: "High piezoelectric properties in LiNbO 3 transferred layer by the Smart Cutâ technology for ultra wide band BAW filter applications", IEDM 2008. IEEE INTERNATIONAL ELECTRON DEVICES MEETING. TECHNICAL DIGEST IEEE PISCATAWAY, NJ, USA, INTERNATIONAL ELECTRON DEVICES MEETING. IEDM TECHNICAL DIGEST, 15 décembre 2008 (2008-12-15), pages 1-4, XP031434540, ISBN: 978-1-4244-2377-4**

EP 2 486 655 B1

**Description**

Le domaine de l'invention est celui des filtres de bande et plus particulièrement celui des filtres à ondes acoustiques.

Le développement des télécommunications radiofréquences depuis une dizaine d'années se traduit par un encombrement des bandes de fréquence autorisées. Pour profiter des plages de fréquence disponibles, les systèmes doivent inclure un filtrage de bande, avec une bande de transition étroite. Seuls les filtres à résonateurs en technologie SAW (ondes de surface) ou BAW (ondes de volume), utilisant les propriétés piézoélectriques des matériaux, permettent de tenir ces spécifications avec de faibles pertes et un encombrement réduit. Aujourd'hui, les couches piézoélectriques utilisées pour ces filtres sont réalisées par dépôt permettant de concevoir des filtres à ondes acoustiques de volume (filtres BAW) ou à partir de substrats massifs permettant de concevoir des filtres à ondes acoustiques de surface (filtres SAW).

Les spécifications demandées par les professionnels des équipements de télécommunications sont de plus en plus difficiles en termes de réjection hors bande et de raideur de transition, sans pour autant se relâcher sur les autres paramètres (pertes d'insertion, variations dans la bande...). La seule façon de redonner un peu de latitude de conception consiste à réduire notablement les variations de fréquence dues à la température.

On rappelle à titre indicatif que la variation de la fréquence de résonance d'un résonateur sur quartz est déterminée par la formule suivante :

$$f(T) = f_0 \left[ 1 + CTF_1 (T-T_0) + CTF_2 (T-T_0)^2 + \ldots \right]$$

avec $f_0$ la fréquence à $T_0$, $T_0$ la température de référence (25°C par convention), $CTF_1$ le coefficient du premier ordre exprimé en ppm/°C et $CTF_2$ le coefficient du second ordre exprimé en ppb/°C$^2$.

Pour CTF1, en passant, par exemple, de 35 ppm/°C à 20 ppm/°C ou moins, il est possible d'améliorer les performances de manière significative et ainsi la compétitivité des produits.

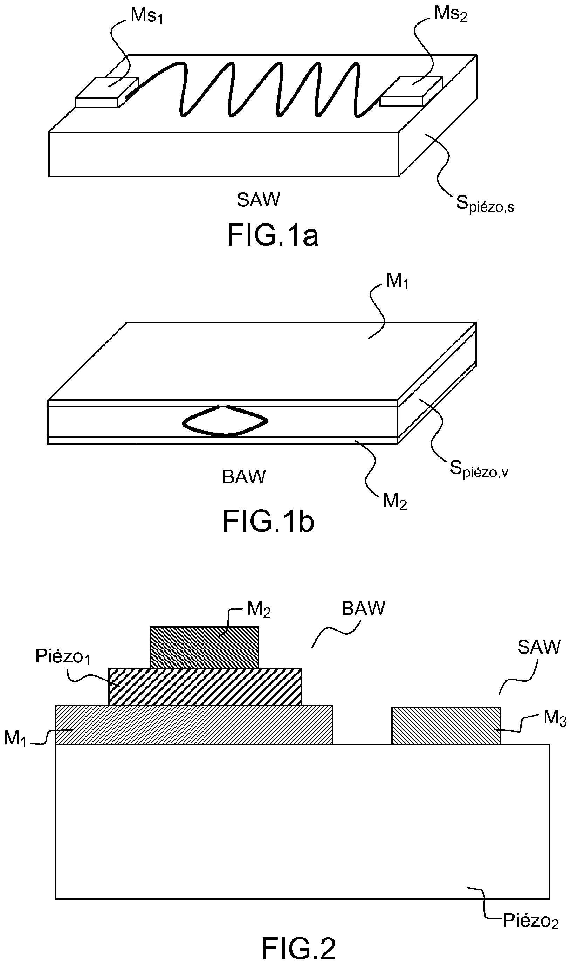

La figure 1a schématise une structure de filtre SAW : sur un substrat piézoélectrique massif $S_{piézo,s}$, des métallisations en surface typiquement pouvant être de type peignes d'électrodes interdigitées $M_{s1}$ et $M_{s2}$ assurent l'excitation du matériau piézoélectrique permettant la propagation d'ondes acoustiques de surface.

Les filtres à ondes de surface restent actuellement la solution standard pour la synthèse et la réalisation de filtres RF dans la gamme 50 MHz - 3 GHz compte tenu de leur robustesse, leur simplicité technologique de mise en oeuvre et la multitude de structures de filtre accessible, offrant au concepteur une véritable stratégie de conception en fonction des spécifications imposées.

Par exemple et bien qu'affectés par des dérives thermiques, les filtres sur tantalate et niobate de lithium permettent de réaliser des largeurs de bande relative supérieures à celles des filtres à ondes de volume grâce à leurs coefficients de couplage élevés (plus de 10%) et leur facteur de qualité Q. Ainsi on peut obtenir des produits $Q \times f_{max}$ des ondes de surface proche de $10^{13}$ alors que ceux obtenus avec les ondes de volume sur films minces restent de l'ordre de $4.10^{12}$.

La figure 1b schématise une structure de filtre à ondes de volume : un substrat piézoélectrique $S_{piézo, v}$ est inséré entre deux métallisations $M_1$ et $M_2$ permettant la propagation d'ondes de volume.

Les filtres à ondes de volume ont été proposés il y a trente ans environ, à des fréquences de quelques MHz à quelques dizaines de MHz, utilisant principalement des éléments d'impédance ou des structures à couplage latéral sur quartz pour des applications à bandes étroites, mais leur mise en oeuvre pour les radiofréquences ne date que d'une dizaine d'années, suite aux travaux pionniers de Lakin (K.M. Lakin et J.S. Wang, UHF composite bulk wave resonators, 1980 IEEE Ultrasonics Symposium Proceedings, pages 834-837) sur l'utilisation de couches piézoélectriques déposées par pulvérisation cathodique à de telles fins.

La société Agilent a été la première à développer un filtre RF de type filtre FBAR correspondant à l'acronyme de « Film Bulk Acoustic Resonator » à base d'éléments d'impédance tirant parti de films minces de nitrure d'aluminium (AlN), matériau polycristallin déposé.

Les résonateurs BAW exploitent la résonance en épaisseur d'une couche piézoélectrique mince qui est isolée acoustiquement du substrat soit par une membrane (technologie FBAR utilisée par la société AVAGO Technologies), soit par un réseau de Bragg (technologie SMR utilisée par la société Infineon).

Le matériau le plus employé en technologie BAW est à l'heure actuelle le Nitrure d'Aluminium (AlN), qui présente l'avantage de présenter des coefficients de couplage piézoélectriques de l'ordre de 6.5 %, et également de présenter de faibles pertes acoustiques et diélectriques, ce qui permet la synthèse de filtres présentant des bandes passantes compatibles avec les spécifications réclamées par la plupart des standards de télécommunication localisés entre 2 et 4 GHz.

Néanmoins, plusieurs problèmes continuent à se poser, face aux spécifications extrêmement contraignantes présentées par quelques bandes de fréquences, telles que le standard DCS.

Les coefficients de couplage piézoélectrique permis par l'AlN n'autorisent pas des bandes passantes relatives supérieures à 3 %. De telles largeurs de bande nécessitent déjà l'utilisation d'électrodes présentant une très forte impédance acoustique (en Molybdène ou en Tungstène), de manière à confiner l'énergie élastique dans la couche piézoélectrique, et des épaisseurs soigneusement déterminées de manière à maximiser leur influence sur le coefficient de couplage piézoélectrique des résonateurs comme décrit dans l'article de R. Aigner, « Bringing BAW technology into volume production: the Ten Commandments and the seven deadly sins », Proceedings of the third international symposium on acoustic wave devices for future mobile communication systems (2007) et dans la publication de J. Kaitila, « Review of wave propagation in BAW thin film devices: progress and prospects », Proceedings of the 2007 IEEE Ultrasonics Symposium.

Il n'existe à l'heure actuelle pas de solutions crédibles pour l'extension de cette bande relative à pertes constantes. De nombreuses recherches sont à ce jour menées pour trouver d'autres matériaux présentant des coefficients de couplage piézoélectrique plus élevés, mais force est de constater qu'il est difficile de mettre en évidence d'autres matériaux proposant de faibles pertes acoustiques et que l'on sache déposer de manière reproductible et uniforme comme décrit dans l'article de P. Murait et al., «Is there a better material for thin film BAW applications than AlN», Proceedings of the 2005 IEEE Ultrasonics Symposium.

A l'inverse, des matériaux monocristallins tels que le Niobate de Lithium ou le Tantalate de Lithium proposent des coefficients de couplages électromécaniques très élevés, permettant la réalisation de filtres présentant des largeurs de bandes relatives de l'ordre de 50 % mais leur mise en oeuvre reste complexe.

Par ailleurs des standards tels que le DCS nécessitent à la fois une large bande passante et une forte réjection des standards adjacents. Répondre simultanément à l'ensemble de ces contraintes nécessite d'utiliser des résonateurs possédant de très forts coefficients de qualité.

De ce fait, les limites imposées par les matériaux eux-mêmes, plus que par la structure, commencent à se profiler, et il est fort probable que des matériaux poly-cristallins ne puissent à terme plus répondre à la montée en coefficients de qualité, surtout face à la montée en fréquence des standards vers les 10 GHz. Avec des coefficients de qualité intrinsèques de l'ordre de la dizaine de milliers à des fréquences supérieures à 1 GHz comme décrit dans l'article de « D. Gachon et al., Filters using high overtone bulk acoustic resonators on thinned single-crystal piezoelectric layer », présenté au 2008 European Frequency and Time Forum, les matériaux monocristallins se présentent là encore comme une solution intéressante.

Les résonateurs BAW à base de nitrure d'aluminium AlN utilisent un mode de vibration longitudinale capable de générer un rayonnement acoustique dans l'air, ce qui est source de pertes acoustiques additionnelles. De plus, les changements de volume associés au mode de compression provoquent des pertes acoustiques accrues à l'intérieur du matériau notamment décrit dans « H.L. Salvo et al., Shear mode transducers for high Q bulk microwave resonators », Proceedings of the 41st Annual Frequency Control Symposium (1987).

Un moyen de réduire ces deux sources de pertes est d'exploiter des ondes de cisaillement, ce qui nécessite l'emploi d'autres matériaux que l'AlN, ou de modifier l'orientation cristalline de couches d'AlN déposées.

Des études se sont intéressées au dépôt de couches d'AlN avec un axe cristallographique c dans le plan du substrat, ou avec un angle de 35° par rapport à la normale, mais la qualité du matériau obtenu s'est avérée moins bonne que dans le cas d'un axe c vertical comme l'ont montré les auteurs, J.S. Wang et al., « Sputtered c-axis piezoelectric films and shear wave resonators », Proceedings of the 37th Annual Frequency Control Symposium (1983).

Il ressort de cet état de l'art qu'en général, chaque type de filtres présente des avantages et des inconvénients. Par exemple les filtres SAW sont connus pour avoir des forts coefficients de couplage permettant un plus fort taux de réjection. Les filtres BAW sont plutôt utilisés pour leurs faibles pertes d'insertion et leur compensation en température plus efficace que sur les SAW.

Ainsi, il peut être intéressant de réaliser un filtre combinant filtre SAW et filtre BAW pour tirer avantage de chaque système. Se pose alors le problème du packaging, pour intégrer un filtre SAW et un filtre BAW dans le même système, avec toute la problématique de place, poids et donc coût associé et d'optimisation des performances de chacun des filtres.

Il a déjà été proposé de co-intégrer un filtre à ondes acoustiques de surface (SAW) et un filtre à ondes acoustiques de volume (BAW) au sein d'un même dispositif, la co-intégration SAW/BAW se faisant au niveau du packaging en mettant cote à cote des filtres BAW et SAW issus de deux ou plusieurs lignes de fabrication distinctes.

Pour ce qui est de la co-intégration sur un même substrat, il a été proposé dans l'article de « N.Lobo, D.C.Malocha : School of Electrical Engineering and Computer Science University of Central Florida, Orando, FL, 1051-0117/06, 2006 IEEE, Ultrasonics Symposium» d'utiliser des électrodes communes pour la réalisation du filtre SAW et celle du filtre BAW, les optimisations desdits deux filtres ne pouvant par la même, être réalisées indépendamment l'une de l'autre.

Il a aussi été proposé dans le brevet US 6 424 238 ou dans la demande de brevet US 2007/0057772, une co-intégration par des approches packaging de deux puces couplées mais peu compactes.

Une approche différente, décrite dans la demande de brevet US 2008/0284541, propose la fabrication d'un substrat pour la réalisation d'un BAW. Il y est mentionné l'intégration d'autres composants (type LED, HEMT ...). Cependant la même couche active est utilisée pour l'ensemble des composants ne permettant pas l'optimisation indépendante de chacun des filtres, respectivement SAW et BAW en l'occurrence.

Il a enfin également été proposé de co-intégrer un BAW et un SAW sur un même substrat avec pour chacun de ces filtres un matériau piézoélectrique dictinct selon la demande de brevet US 2008/024245.

Dans ce contexte, le demandeur propose dans la présente invention, de réaliser une structure comprenant également la co-intégration d'un BAW et d'un SAW, ledit BAW étant réalisé à partir d'un matériau piézoélectrique monocristallin et ce afin d'obtenir un meilleur coefficient de qualité intrinsèque et grâce à l'emploi de procédés spécifiques d'élaboration.

L'invention a pour objet un procédé de fabrication d'un dispositif à ondes acoustiques comportant au moins un filtre à ondes acoustiques de surface et un filtre à ondes acoustiques de volume selon l'invention caractérisé en ce qu'il comporte les étapes suivantes :

- la formation d'un empilement comportant au moins une couche de second matériau piézoélectrique, une couche de première métallisation ($M_1$) et une couche d'un premier matériau piézoélectrique monocristallin, comportant le report de la couche de premier matériau piézoélectrique associée à la couche de première métallisation sur la couche de second matériau piézoélectrique ;
- la gravure partielle dudit empilement de manière à définir une première zone dans laquelle les premier et second matériaux piézoélectriques sont présents et une seconde zone dans laquelle le premier matériau piézoélectrique et la couche de première métallisation sont absents;
- la réalisation d'une seconde métallisation au niveau de la première zone pour définir le filtre à ondes acoustiques de volume intégrant le premier matériau piézoélectrique et une troisième métallisation au niveau de la seconde zone pour définir le filtre à ondes acoustiques de surface intégrant le second matériau piézoélectrique.

Selon une variante de l'invention, le report de la couche de premier matériau piézoélectrique associée à la couche de première métallisation sur la couche de second matériau piézoélectrique comporte :

- la définition d'une couche mince de premier matériau piézoélectrique au sein d'un substrat de premier matériau piézoélectrique comportant une couche supérieure de première métallisation définissant un premier ensemble ;
- l'assemblage dudit premier ensemble comportant ladite couche mince de premier matériau piézoélectrique défini au sein d'un substrat de premier matériau piézoélectrique côté première métallisation sur le second matériau piézoélectrique ;
- la séparation dudit substrat de premier matériau piézoélectrique de ladite couche mince de premier matériau piézoélectrique.

Selon une variante de l'invention, la définition de la couche mince de premier matériau piézoélectrique comporte les étapes suivantes :

- la métallisation d'un substrat comportant au moins en surface le premier matériau piézoélectrique ;
- l'implantation d'ions dans ledit substrat pour créer dans le premier matériau piézoélectrique une zone fragile enterrée définissant la couche mince de premier matériau piézoélectrique.

Selon une variante de l'invention, l'implantation ionique est réalisée avec des ions hydrogène et /ou des ions hélium.

Selon une variante de l'invention, la séparation est réalisée par traitement thermique.

Selon une variante de l'invention, le report de la couche de premier matériau piézoélectrique associée à la couche de première métallisation sur la couche de second matériau piézoélectrique comprend :

- une étape d'assemblage d'un premier substrat comportant au moins une couche de premier matériau piézoélectrique recouvert d'une couche supérieure de première métallisation avec un second matériau piézoélectrique et
- une étape d'amincissement du premier substrat par rodage / polissage de manière à définir une couche mince de premier matériau piézoélectrique.

Selon une variante de l'invention, l'assemblage est effectué par collage moléculaire.

Selon une variante de l'invention, le premier ensemble comprend une première couche de collage, le second matériau piézoélectrique étant recouvert d'une seconde couche de collage.

Selon une variante de l'invention, le premier ensemble comporte une couche de découplage.

Selon une variante de l'invention, la couche de second matériau piézoélectrique est constituée par la partie superficielle d'un substrat massif de second matériau piézoélectrique.

Selon une variante de l'invention, la couche de second matériau piézoélectrique ($P_{iézo2}$) est déposée ou épitaxiée ou reportée sur un substrat.

L'invention sera mieux comprise et d'autres avantages apparaîtront à la lecture de la description qui va suivre donnée à titre non limitatif et grâce aux figures annexées parmi lesquelles :

- les figures 1a et 1b illustrent respectivement des structures à ondes acoustiques de surface et à ondes acoustiques de volume ;
- la figure 2 illustre un exemple de dispositif selon l'invention ;
- la figure 3 illustre les principales étapes d'un procédé de report de film à base d'implantation/fracture ;
- les figures 4a à 4h illustrent les différentes étapes d'un exemple de procédé de fabrication d'un dispositif selon l'invention.

De manière générale, le dispositif de l'invention comprend comme illustré en figure 2, un substrat comportant au moins en surface un matériau piézoélectrique.

Avantageusement et comme décrit ci-après, le substrat peut être le matériau piézoélectrique $P_{iézo2}$ sur lequel est disposé un empilement comportant une couche de métal $M_1$, une couche de matériau piézoélectrique $P_{iézo1}$ et une couche de métal $M_2$, définissant ainsi une première zone dans laquelle est réalisé le filtre à ondes acoustiques de volume de type BAW. Avantageusement une couche de découplage acoustique est prévue entre le deuxième matériau piézoélectrique et la couche de métal $M_1$ pour découpler les deux couches piézoélectriques.

Le substrat $P_{iézo2}$ comporte par ailleurs dans une seconde zone, un ensemble métallisé $M_3$ permettant de définir un jeu d'électrodes à la surface dudit matériau piézoélectrique de manière à réaliser le filtre à ondes acoustiques de surface.

Les matériaux piézoélectriques peuvent être de différents types : ils peuvent être polycristallins notamment lorsqu'ils sont déposés et éventuellement recuits (cas de $SrTiO_3$ ou $PbZrTiO_3$ ou $AlN$ ou $ZnO$), ils sont avantageusement monocristallins lorsqu'ils sont reportés (cas $LiNbO_3$, $LiTaO_3$, $La_3Ga_5SiO_{14}$, $La_3Ga_{5.5}Ta_{0.5}O_{14}$).

Un procédé de fabrication particulièrement adapté à la fabrication d'un dispositif de l'invention va être décrit ci-après.

Afin de réaliser la couche mince de matériau $P_{iézo1}$ monocristallin, on peut avantageusement avoir recours à deux types de techniques existantes de report de couches minces permettant de conserver le caractère monocristallin du substrat de départ dans lequel cette couche mince est prélevée: une première technique basée sur l'implantation d'ions gazeux (typiquement hydrogène) dite technique d'implantation/fracture, et une deuxième technique basée sur un amincissement mécanique après collage dit technique de collage / amincissement mécanique.

Ces techniques permettent de reporter une couche monocristalline sur un substrat de réception ou substrat hôte. Ces techniques sont parfaitement maîtrisées sur Silicium permettant entre autres la fabrication industrielle de plaquettes SOI (Silicon On Insulator). Ces deux techniques se différencient par la gamme d'épaisseur de matériau que l'on cherche à reporter, le procédé par collage /amincissement mécanique étant limité à des épaisseurs de l'ordre de quelques microns minimum, le procédé par implantation/fracture permettant quant à lui d'atteindre de très faibles épaisseurs typiquement pouvant être inférieures à environ 0,5 $\mu$m mais étant limité pour les valeurs supérieures à 2$\mu$m avec un implanteur classique de la microélectronique et à quelques dizaines de $\mu$m avec des implanteurs haute énergie.

Le procédé de report par implantation/fracture est notamment décrit dans l'article : "Silicon on insulator material technology", Electronic letters, 31 (14), p1201-1202 (1995), il permet notamment la réalisation de substrats SOI « Silicon On Insulator » correspondant à du silicium sur isolant.

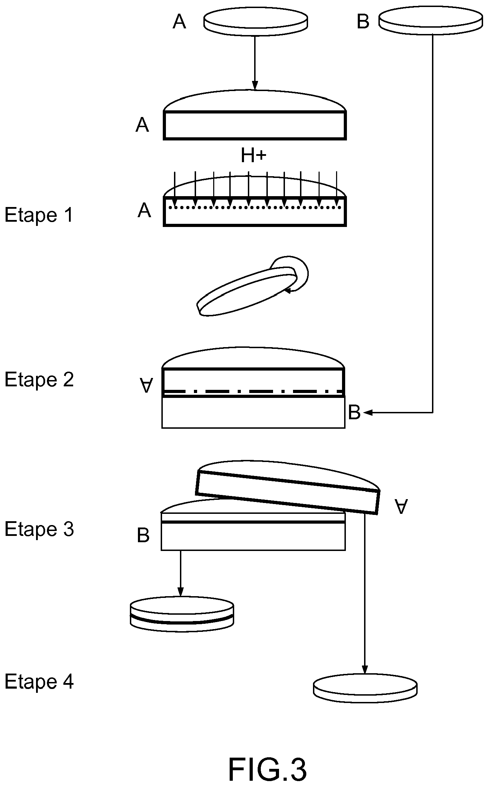

Ce procédé peut être schématiquement résumé par les quatre étapes suivantes illustrées en figure 3 :

Etape 1 : Un substrat donneur A, par exemple de silicium est implanté par des espèces gazeuses (par exemple de l'hydrogène et/ou des gaz rares) pour former une zone fragile enterrée, délimitant dans ce substrat le film mince à transférer.

Etape 2 : Le substrat donneur est ensuite assemblé au niveau du film mince précédemment défini, par exemple par collage direct (encore appelé collage moléculaire), avec un substrat de réception B.

Etape 3 : Une étape de fracture est ensuite obtenue au niveau de la zone fragile enterrée au moyen d'un traitement thermique éventuellement assisté de l'application de contraintes mécaniques. On obtient alors d'une part le film mince solidaire du substrat de réception, et d'autre part le reliquat du substrat donneur correspondant au substrat donneur initial A, pelé du film mince transféré. Ce dernier peut alors être recyclé pour la réalisation d'un autre transfert.

Etape 4 : Eventuellement, des traitements finaux peuvent être réalisés, par exemple un recuit à haute température pour consolider l'interface de collage entre le film mince transféré et le substrat de réception

L'épaisseur du film mince transféré est directement reliée à l'énergie d'implantation du faisceau d'ions. A titre d'exemple, l'épaisseur de silicium transférée peut aller de quelques dizaines de nm à environ $2\mu m$ en utilisant un implanteur conventionnel (énergie < 210keV).

Les couches transférées sont uniformes et homogènes en épaisseur car définies par une profondeur d'implantation et non par un amincissement mécanique.

C'est un procédé flexible qui permet par exemple la réalisation d'hétérostructures. Outre le silicium, différents matériaux ont déjà été transférés par le biais de cette technique :

- le SiC : L. DiCioccio, F. Letertre, Y. Le Tiec, A.M. Papon, C. Jaussaud and M. Bruel : "Silicon carbide on insulator formation by Smart Cut™ process", Master. Sci. Eng., vol.B46, pp.349-356 (1997);
- le GaAs : E. Jalaguier, B. Aspar, S. Pocas, J.F. Michaud, M. Zussy, A.M. Papon and M. Bruel : "Transfer of thin GaAs film on silicon substrate by proton implantation process", Electronic letters, vol.34, N°4, pp.408-409 (1998).;
- l'InP : E. Jalaguier, B. Aspar, S. Pocas, J.F. Michaud, A.M. Papon and M. Bruel : "Transfer of thin InP film onto silicon substrate by proton implantation process", IEEE Proc.11th International Conférence on Indium Phosphide and Related Materials, Davos (Switzerland) (1999);
- le GaN : A. Tauzin, T. Akatsu, M. Rabarot, J. Dechamp : "Transfers of 2-inch GaN films onto sapphire substrates using Smart CutTM technology", Electronics Letters 26th May 2005 Vol. 41 No. 11;
- ou le Ge : C. Deguet et al - 200 mm Germanium-On-Insulator (GeOI) structures realized from epitaxial Germanium wafers by the Smart Cut™ technology - Electro Chemical Society 2005.

Ces transferts peuvent être réalisés sur différents substrats récepteurs : quartz, Si, Ge, GaAs, saphir,....

Un tel procédé permet donc de proposer sans de forte perturbation de la technologie, l'intégration d'électrodes ou filtres de Bragg, particulièrement adapté à la problématique de la présente invention. En effet, aujourd'hui dans la majorité des composants pour les micro-systèmes MEMS, les couches de matériaux piézoélectriques sont réalisées par des techniques de dépôts de type PVD ou sol gel. En général, les couches à élaborer pour ces composants sont dans une gamme d'épaisseurs comprises entre quelques centaines de nm et le micron. C'est pourquoi la maîtrise de la fabrication de couches piézoélectriques et électrostrictives monocristallines pour cette gamme d'épaisseurs constitue un verrou technologique important.

Des études ont montré la possibilité de transférer par implantation / fracture des couches piézoélectriques. On se référera notamment à la publication : Integration of single-crystal $LiNbO_3$ thin film on silicon by laser irradiation and ion implantation-induced layer transfer, Y.B. Park, B. Min, J. Vahala and H.A. Atwater, Advanced Materials, vol 18 (2006) 1533. Ces auteurs montrent la réalisation d'un transfert de 800 nm de $LiNbO_3$ par co-implantation d'ions H à 80 keV avec une dose de 5e16 ions/$cm^2$ et une énergie d'hélium de 115 keV avec une dose de 1e17 ions/$cm^2$. L'originalité de cette publication est dans le mécanisme de transfert qui se fait à l'aide d'un laser cw-CO2 (100 MW.$m^{-2}$) utilisé comme source de chaleur à cette fin.

Une étude menée par M. Alexe : « Ferroelectric oxide single-crystalline layers by wafer bonding and Hydrogen/Helium implantation, I. Radu, I. Szafraniak, R. Scholz, M. Alexe, U. Gösele, Mat. Res. Soc. Symp. Proc., vol 748 (2003) » s'est attachée à trouver les conditions optimales de cloquage (conditions déterminantes d'un transfert par implantation /fracture) pour différents matériaux, tels que $LiNbO_3$, $LaAlO_3$, $SrTiO_3$ voire même du $PbZrTiO_3$, en utilisant des ions Hélium et Hydrogène. Des études similaires, ont été faites dans le $LiTaO_3$ : « Investigation of H+ and B+/H+ implantation in LiTaO3 single crystals » Nuclear Instruments and Methods in Physics Research, B 184 (2001) p53, à l'aide d'implantation H+ et co-implantation B+/H+, ces auteurs se sont essentiellement attachés à caractériser les dommages créés par l'implantation et l'effet des recuits de guérison.

Enfin la demanderesse a elle-même proposé des solutions de transfert de LiNbO3 selon la technologie implantation/ fracture : J-S. Moulet and al ; "High piezoelectric properties in LiNbO3 transferred layer by the Smart Cut technology for ultra wide band BAW filter application, IEDM 2008 - IEEE- International -Electron -Devices -Meeting.-Technical - Digest. 2008.

C'est pourquoi, un procédé de l'invention particulièrement adapté à la conception de dispositif de l'invention, propose de coupler l'avantage de la réalisation de filtres SAW et BAW sur des matériaux piézoélectriques en couche mince monocristalline, à celui de pouvoir réaliser sur le même substrat un composant SAW et un composant BAW par une technologie de report de couches minces monocristallines (notamment t par implantation / fracture), laissant par la même plus de latitude quant au choix de l'orientation cristalline et à l'optimisation indépendante de chaque type de composant.

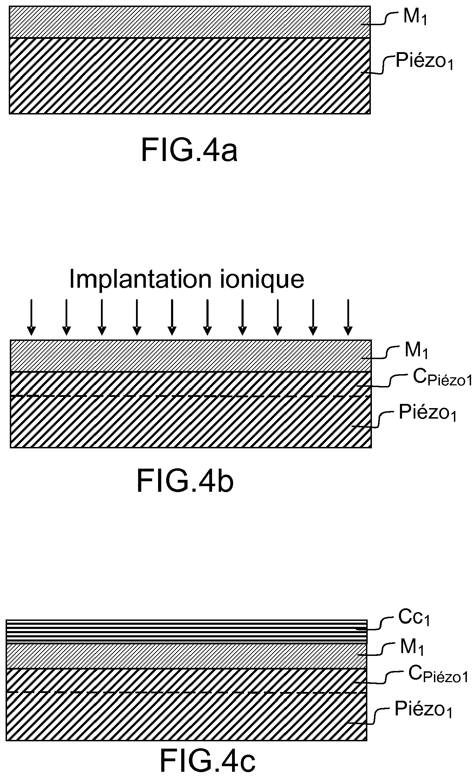

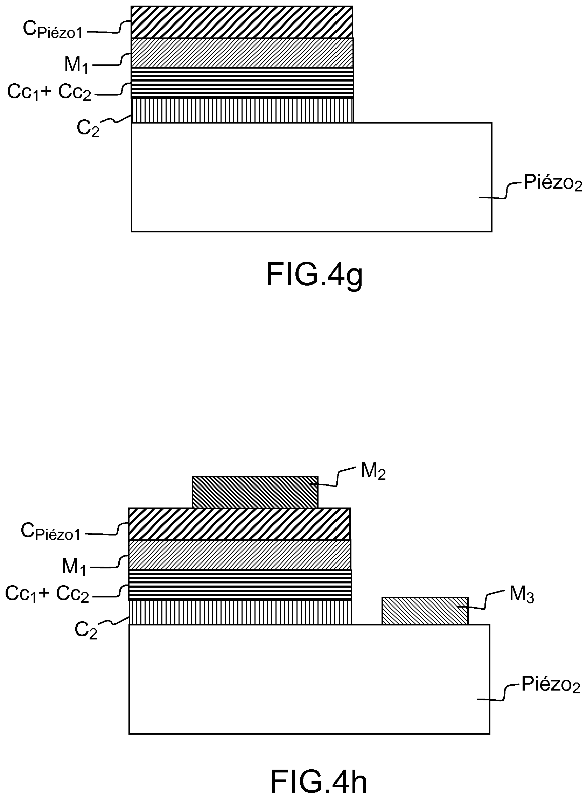

Les figures 4a à 4i illustrent ainsi les différentes étapes d'un tel procédé.

On réalise le dépôt d'une couche métallique $M_1$ sur un substrat de premier matériau piézoélectrique $P_{iézo1}$, comme illustré en figure 4a.

On procède alors à une opération d'implantation ionique par exemple à base de H+, de He ou un mélange des deux types selon la nature du matériau piézoélectrique avec des doses comprises entre $1.10^{16}$ et $1.10^{17}$ at/$cm^2$, et avec

une énergie comprise entre 50 keV et 240 keV selon l'épaisseur à transférer, comme illustré en figure 4b, pour créer une zone fragile enterrée permettant de définir la couche mince piézoélectrique à transférer $C_{piézo1}$ au sein du substrat piézoélectrique $P_{iézo1}$. On notera que si les conditions thermiques le permettent, l'implantation peut être réalisée avant le dépôt de la couche métallique $M_1$.

Avantageusement, une couche $C_{c1}$ de collage de quelques dizaines voire centaines de nm est déposée par la suite par-dessus la couche métallique comme illustré en figure 4c, par exemple un oxyde de silicium basse température est utilisé (déposé par exemple par Ion Beam Sputtering) suffisamment dense pour ne pas demander de densification. Cette couche est ensuite préparée pour être compatible d'une opération de collage direct, par exemple par une préparation par polissage (de type CMP : polissage mécano chimique avec slurry à base de silice colloïdale) qui permet d'obtenir la rugosité et l'activation chimique de la surface souhaitées pour le collage direct.

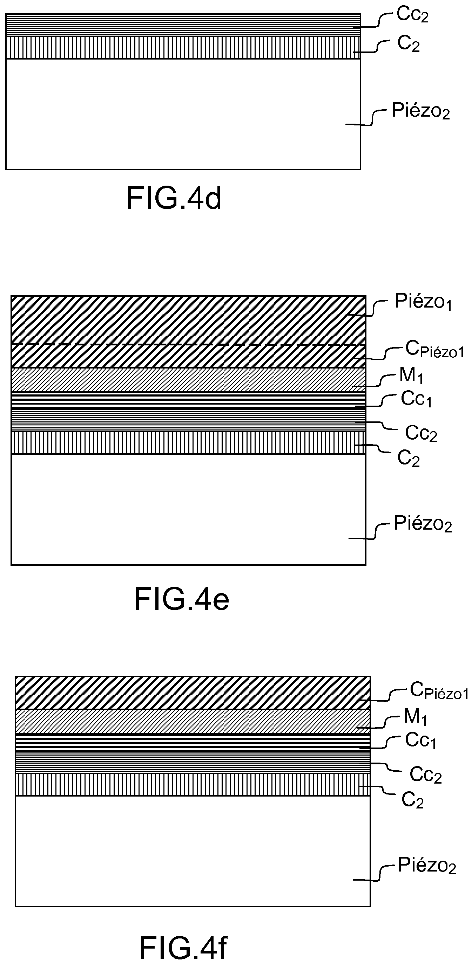

En parallèle, à partir d'un substrat de second matériau piézoélectrique $P_{iézo2}$, massif monocristallin, on réalise avantageusement le dépôt d'une couche $C_2$ intermédiaire (qui peut servir de couche de découplage acoustique soit directement s'il s'agit d'un réseau de Bragg, soit après élimination, l'air remplaçant la couche éliminée servant alors au découplage proprement dit), et le dépôt d'une couche de collage $C_{c2}$ adaptée à une opération de collage moléculaire ultérieure, comme illustré en figure 4d. Plus précisément, un substrat piézoélectrique (par exemple de type LiNbO3, LiTaO3 ...) massif, est choisi pour l'application SAW (en terme d'orientation, de nature de matériau ...).

La couche $C_2$ peut comporter par exemple une couche sacrificielle, ou bien un réseau de Bragg (alternances de couches de W/SiO2 de plusieurs centaines de nm), avec une couche par exemple de $SiO_2$ en surface destinée à servir a posteriori pour le collage et servant de couche de collage Cc2. De même, la couche de collage Cc1 peut faire partie intégrante du réseau de Bragg disposé à terme entre le deuxième matériau piézoélectrique et la première couche métallique M1.

Les couches Cc1 et Cc2 peuvent avoir également un rôle dans la compensation de la variation en température du matériau piézoélectrique lorsque le SAW est compensé. Des couches supplémentaires peuvent également être prévues pour assurer cette compensation.

Les deux substrats sont ensuite collés par collage moléculaire comme illustré en figure 4e.

Un traitement thermique est ensuite appliqué (entre 100°C et 500°C, préférentiellement 250°C) afin d'initier le transfert du film mince de premier matériau $P_{iezo1}$ comme illustré en figure 4f permettant de séparer la couche mince piézoélectrique à transférer $C_{piézo1}$ du reste du substrat de premier matériau piézoélectrique.

Des procédés de finition non représentés (tel que traitement thermique et/ou polissage pour obtenir une rugosité compatible avec la réalisation ultérieure de composants) peuvent être effectués.

Une partie de l'empilement ainsi réalisé est alors gravé de manière à définir deux zones respectivement dédiées à la formation d'un filtre à ondes acoustiques de volume et à la formation d'un filtre à ondes acoustiques de surface, comme illustré en figure 4g.

Plus précisément les couches supérieures sont gravées par exemple par gravure sèche, pour mettre à nu la couche de matériau $P_{iézo2}$ de manière à pouvoir réaliser et optimiser les deux composants de façon indépendante l'un par rapport à l'autre (en terme de design / matériau des électrodes ...).

On procède ensuite à la réalisation de la métallisation $M_2$ correspondant à l'électrode supérieure du filtre de type BAW, l'électrode inférieure étant constituée par la métallisation $M_1$. On procède également, à la réalisation de la métallisation $M_3$ en surface du matériau $P_{iézo2}$ dans laquelle on effectue le « design » d'électrodes nécessaires à la conception du filtre SAW , comme illustré en figure 3.

Il est possible à ce stade, si une couche de découplage sacrificielle a été prévue, de l'éliminer par exemple par gravure sélective pour laisser entre la couche de second matériau piézoélectrique et la couche de métallisation $M_1$ de l'air assurant le découplage acoustique entre les deux couches piézoélectriques.

Différentes alternatives au procédé précédemment décrit peuvent être envisagées :
En effet, une approche alternative pour obtenir l'opération de transfert peut consister à assembler les deux substrats par exemple par collage direct puis à amincir le substrat de premier matériau piézoélectrique $P_{iézo1}$ par une étape de rodage / polissage. Les épaisseurs de matériau obtenues dans ce cas sont en général supérieurs à quelques $\mu m$.

Selon une autre variante, le substrat massif de matériau $P_{iézo2}$ peut être remplacé par un substrat composite formé d'un substrat hôte (par exemple un matériau adapté pour la compensation en température de type saphir, silicium, quartz ....) sur lequel est transféré (par implantation /fracture ou collage / amincissement mécanique) ou déposée ou épitaxiée une couche piézoélectrique. On peut citer par exemple l'épitaxie d'AlN sur un substrat de saphir.

De même le substrat massif de matériau $P_{iézo1}$ dans lequel est réalisée la couche mince de premier matériau piézoélectrique peut être remplacé par un substrat composite formé d'un substrat hôte (par exemple un matériau adapté pour la compensation en température de type saphir, silicium, quartz ....) sur lequel est transféré (par implantation /fracture ou collage / amincissement mécanique) ou déposée ou épitaxiée une couche de premier matériau piézoélectrique.

**Revendications**

1.  Procédé de fabrication d'un dispositif à ondes acoustiques comportant au moins un filtre à ondes acoustiques de surface (SAW) et un filtre à ondes acoustiques de volume (BAW), **caractérisé en ce qu'**il comporte les étapes suivantes :

    - la formation d'un empilement comportant au moins une couche de second matériau piézoélectrique ($P_{iézo2}$), une couche de première métallisation ($M_1$) et une couche d'un premier matériau piézoélectrique ($P_{iézo1}$) monocristallin, comportant le report de la couche de premier matériau piézoélectrique ($P_{iézo1}$) associée à la couche de première métallisation ($M_1$) sur la couche de second matériau piézoélectrique ($P_{iézo2}$) ;
    - la gravure partielle dudit empilement de manière à définir une première zone dans laquelle les premier et second matériaux piézoélectriques sont présents et une seconde zone dans laquelle le premier matériau piézoélectrique et la couche de première métallisation sont absents
    - la réalisation d'une seconde métallisation ($M_2$) au niveau de la première zone pour définir le filtre à ondes acoustiques de volume intégrant le premier matériau piézoélectrique et une troisième métallisation ($M_3$) au niveau de la seconde zone pour définir le filtre à ondes acoustiques de surface intégrant le second matériau piézoélectrique.

2.  Procédé de fabrication d'un dispositif à ondes acoustiques selon la revendication 1, **caractérisé en ce que** le report de la couche de premier matériau piézoélectrique ($P_{iézo1}$) associée à la couche de première métallisation ($M_1$) sur la couche de second matériau piézoélectrique ($P_{iézo2}$) comporte :

    - la définition d'une couche mince de premier matériau piézoélectrique au sein d'un substrat de premier matériau piézoélectrique comportant une couche supérieure de première métallisation définissant un premier ensemble ;
    - l'assemblage dudit premier ensemble comportant ladite couche mince de premier matériau piézoélectrique défini au sein d'un substrat de premier matériau piézoélectrique côté première métallisation sur le second matériau piézoélectrique ;
    - la séparation dudit substrat de premier matériau piézoélectrique de ladite couche mince de premier matériau piézoélectrique.

3.  Procédé de fabrication d'un dispositif à ondes acoustiques selon la revendication 2, **caractérisé en ce que** la définition de la couche mince de premier matériau piézoélectrique comporte les étapes suivantes :

    - la métallisation d'un substrat comportant au moins en surface le premier matériau piézoélectrique ;
    - l'implantation d'ions dans ledit substrat pour créer dans le premier matériau piézoélectrique une zone fragile enterrée définissant la couche mince de premier matériau piézoélectrique.

4.  Procédé de fabrication d'un dispositif à ondes acoustiques selon la revendication 3, **caractérisé en ce que** l'implantation ionique est réalisée avec des ions hydrogène et /ou des ions hélium.

5.  Procédé de fabrication d'un dispositif à ondes acoustiques selon la revendication 2, **caractérisé en ce que** la séparation est réalisée par traitement thermique.

6.  Procédé de fabrication d'un dispositif à ondes acoustiques selon la revendication 1, **caractérisé en ce que** le report de la couche de premier matériau piézoélectrique ($P_{iézo1}$) associée à la couche de première métallisation ($M_1$) sur la couche de second matériau piézoélectrique ($P_{iézo2}$) comprend :

    - une étape d'assemblage d'un premier substrat comportant au moins une couche de premier matériau piézoélectrique recouvert d'une couche supérieure de première métallisation avec un second matériau piézoélectrique et
    - une étape d'amincissement du premier substrat par rodage / polissage de manière à définir une couche mince de premier matériau piézoélectrique.

7.  Procédé de fabrication d'un dispositif à ondes acoustiques selon l'une des revendications 2 à 6, **caractérisé en ce que** l'assemblage est effectué par collage moléculaire.

8.  Procédé de fabrication d'un dispositif à ondes acoustiques selon l'une des revendications 2 à 7, **caractérisé en ce que** le premier ensemble comprend une première couche de collage, le second matériau piézoélectrique étant recouvert d'une seconde couche de collage.

9. Procédé de fabrication d'un dispositif à ondes acoustiques selon la revendication 8, **caractérisé en ce que** le premier ensemble comporte une couche de découplage.

10. Procédé de fabrication d'un dispositif à ondes acoustiques selon l'une des revendications 1 à 9, **caractérisé en ce que** la couche de second matériau piézoélectrique ($P_{iézo2}$) est constituée par la partie superficielle d'un substrat massif de second matériau piézoélectrique.

11. Procédé de fabrication d'un dispositif à ondes acoustiques selon l'une des revendications 1 à 10, **caractérisé en ce que** la couche de second matériau piézoélectrique ($P_{iézo2}$) est déposée ou épitaxiée ou reportée sur un substrat.

12. Procédé de fabrication d'un dispositif à ondes acoustiques selon l'une des revendications 1 à 11, **caractérisé en ce que** le second matériau piézoélectrique est de type $LiNbO_3$, $LiTaO_3$, $La_3Ga_5SiO_{14}$ (langasite), $La_3Ga_{5.5}Ta_{0.5}O_{14}$ (langatate).

13. Procédé de fabrication d'un dispositif à ondes acoustiques selon l'une des revendications 1 à 11, **caractérisé en ce que** le second matériau piézoélectrique est de type $SrTiO_3$ (STO) ou $PbZrTiO_3$ (PZT) ou AIN ou ZnO.

14. Procédé de fabrication d'un dispositif à ondes acoustiques selon l'une des revendications 1 à 13, **caractérisé en ce que** le premier matériau piézoélectrique est de type $LiNbO_3$ (LNO), $LiTaO_3$ (LTO), $La_3Ga_5SiO_{14}$ (langasite), $La_3Ga_{5.5}Ta_{0.5}O_{14}$ (langatate), $SrTiO_3$ (STO), $PbZrTiO_3$ (PZT), AIN, ZnO.

15. Procédé de fabrication d'un dispositif à ondes acoustiques selon l'une des revendications 1 à 14, **caractérisé en ce que** la première couche métallique est en métal de type cuivre (Cu), alliage de cuivre et d'aluminium (AlCu), tungstène (W), Molybdène (Mo), AISi, Cr.

16. Procédé de fabrication d'un dispositif à ondes acoustiques selon l'une des revendications 7 à 15, **caractérisé en ce que** le collage moléculaire est effectué avec une couche de collage moléculaire insérée entre la première métallisation et le second matériau piézoélectrique de type oxyde basse température de type $SiO_2$.

**Patentansprüche**

1. Verfahren zum Herstellen einer Schallwellenvorrichtung, welche mindestens einen Oberflächenschwallwellenfilter (SAW) und einen Volumenschallwellenfilter (BAW) umfasst, **dadurch gekennzeichnet, dass** es folgende Schritte umfasst:

- das Bilden eines Stapels, welcher mindestens eine Schicht aus einem zweiten piezoelektrischen Material ($P_{iezo2}$), eine Schicht einer ersten Metallisierung ($M_1$) und eine Schicht aus einem ersten, monokristallinen piezoelektrischen Material ($P_{iezo1}$) beinhaltet, beinhaltend das Übertragen der Schicht aus dem ersten piezoelektrischen Material ($P_{iezo1}$), welche mit der Schicht der ersten Metallisierung ($M_1$) verbunden ist, auf die Schicht aus dem zweiten piezoelektrischen Material ($P_{iezo2}$);
- das teilweise Gravieren des Stapels so, dass eine erste Zone definiert wird, in welcher das erste und das zweite piezoelektrische Material vorhanden sind und eine zweite Zone definiert wird, in welcher das erste piezoelektrische Material und die Schicht der ersten Metallisierung nicht vorhanden sind;
- Erzeugen einer zweiten Metallisierung ($M_2$) in der ersten Zone, um den Volumenschallwellenfilter zu definieren, welcher das erste piezoelektrische Material und eine dritte Metallisierung ($M_3$) in der zweiten Zone beinhaltet, um den Oberflächenschwallwellenfilter zu definieren, welcher das zweite piezoelektrische Material umfasst.

2. Verfahren zum Herstellen einer Schallwellenvorrichtung nach Anspruch 1, **dadurch gekennzeichnet, dass** die Übertragung der Schicht aus dem ersten piezoelektrischen Material ($P_{iezo1}$), welche mit der Schicht der ersten Metallisierung ($M_1$) verbunden ist, auf die Schicht aus dem zweiten piezoelektrischen Material ($P_{iezo2}$) Folgendes umfasst:

- Definieren einer dünnen Schicht aus dem ersten piezoelektrischen Material innerhalb eines Substrates aus dem ersten piezoelektrischen Material, welches eine obere Schicht der ersten Metallisierung umfasst, welche eine erste Anordnung definiert;

- Zusammenfügen der ersten Anordnung, welche die dünne Schicht aus dem ersten piezoelektrischen Material umfasst, welche innerhalb eines Substrates aus dem ersten piezoelektrischen Material auf der Seite der ersten Metallisierung auf dem zweiten piezoelektrischen Material definiert ist;
- Trennen des Substrates aus dem ersten piezoelektrischen Material von der dünnen Schicht aus dem ersten piezoelektrischen Material.

3. Verfahren zum Herstellen einer Schallwellenvorrichtung nach Anspruch 2, **dadurch gekennzeichnet, dass** das Definieren der dünnen Schicht aus dem ersten piezoelektrischen Material folgende Schritte umfasst:

- Metallisieren eines Substrates, welches mindestens an der Oberfläche das erste piezoelektrische Material umfasst;
- Einbringen von Ionen in das Substrat, um in dem ersten piezoelektrischen Material eine unterirdische fragile Zone zu schaffen, welche die dünne Schicht aus erstem piezoelektrischen Material definiert.

4. Verfahren zum Herstellen einer Schallwellenvorrichtung nach Anspruch 3, **dadurch gekennzeichnet, dass** das Einbringen von Ionen mit Wasserstoffionen und/oder Heliumionen erfolgt.

5. Verfahren zum Herstellen einer Schallwellenvorrichtung nach Anspruch 2, **dadurch gekennzeichnet, dass** das Trennen durch thermische Behandlung erfolgt.

6. Verfahren zum Herstellen einer Schallwellenvorrichtung nach Anspruch 1, **dadurch gekennzeichnet, dass** die Übertragung der Schicht aus dem ersten piezoelektrischen Material ($P_{iezo1}$), welche mit der Schicht der ersten Metallisierung ($M_1$) verbunden ist, auf die Schicht aus dem zweiten piezoelektrischen Material ($P_{iezo2}$) Folgendes umfasst:

- einen Schritt des Zusammenfügens eines ersten Substrates, welches mindestens eine Schicht aus dem ersten piezoelektrischen Material umfasst, welche mit einer oberen Schicht der ersten Metallisierung bedeckt ist, mit einem zweiten piezoelektrischen Material und
- einen Schritt des Verschmälerns des ersten Substrates durch Läppen/Polieren so, dass eine dünne Schicht aus dem ersten piezoelektrischen Material definiert wird.

7. Verfahren zum Herstellen einer Schallwellenvorrichtung nach einem der Ansprüche 2 bis 6, **dadurch gekennzeichnet, dass** das Zusammenfügen durch molekulares Verkleben erfolgt.

8. Verfahren zum Herstellen einer Schallwellenvorrichtung nach einem der Ansprüche 2 bis 7, **dadurch gekennzeichnet, dass** die erste Anordnung eine erste Klebeschicht umfasst, wobei das zweite piezoelektrische Material mit einer zweiten Klebeschicht bedeckt ist.

9. Verfahren zum Herstellen einer Schallwellenvorrichtung nach Anspruch 8, **dadurch gekennzeichnet, dass** die erste Anordnung eine Entkopplungsschicht umfasst.

10. Verfahren zum Herstellen einer Schallwellenvorrichtung nach einem der Ansprüche 1 bis 9, **dadurch gekennzeichnet, dass** die Schicht aus dem zweiten piezoelektrischen Material ($P_{iezo2}$) aus dem oberflächlichen Teil eines massiven Substrates aus dem zweiten piezoelektrischen Material besteht.

11. Verfahren zum Herstellen einer Schallwellenvorrichtung nach einem der Ansprüche 1 bis 10, **dadurch gekennzeichnet, dass** die Schicht aus dem zweiten piezoelektrischen Material ($P_{iezo2}$) auf einem Substrat abgelagert, darauf epitaxiert oder darauf übertragen wird.

12. Verfahren zum Herstellen einer Schallwellenvorrichtung nach einem der Ansprüche 1 bis 11, **dadurch gekennzeichnet, dass** das zweite piezoelektrische Material ein Material vom Typ $LiNbO_3$, $LiTaO_3$, $La_3Ga_5SiO_{14}$ (Langasit), $La_3Ga_{5,5}Ta_{0,5}O_{14}$ (Langatat) ist.

13. Verfahren zum Herstellen einer Schallwellenvorrichtung nach einem der Ansprüche 1 bis 11, **dadurch gekennzeichnet, dass** das zweite piezoelektrische Material ein Material vom Typ $SrTiO_3$ (STO) oder $PbZrTiO_3$ (PZT) oder AlN oder ZnO ist.

14. Verfahren zum Herstellen einer Schallwellenvorrichtung nach einem der Ansprüche 1 bis 13, **dadurch gekenn-**

**zeichnet, dass** das erste piezoelektrische Material ein Material vom Typ LiNbO$_3$ (LNO), LiTaO$_3$ (LTO), La$_3$Ga$_5$SiO$_{14}$ (Langasit), La$_1$Ga$_{5,5}$Ta$_{0,5}$O$_{14}$ (Langatat), SrTiO$_3$ (STO), PbZrTiO$_3$ (PZT), AIN oder ZnO ist.

15. Verfahren zum Herstellen einer Schallwellenvorrichtung nach einem der Ansprüche 1 bis 14, **dadurch gekennzeichnet, dass** die erste Metallschicht aus einem Metall vom Typ Kupfer (Cu), Kupfer-Aluminium-Legierung (AlCu), Wolfram (W), Molybdän (Mo), AlSi, Cr besteht.

16. Verfahren zum Herstellen einer Schallwellenvorrichtung nach einem der Ansprüche 7 bis 15, **dadurch gekennzeichnet, dass** die molekulare Verklebung mit einer molekularen Klebeschicht erfolgt, welche zwischen die erste Metallisierung und das zweite piezoelektrische Material vom Typ Niedertemperaturoxid vom Typ SiO$_2$ eingesetzt wird.

## Claims

1. Method for fabricating an acoustic wave device comprising at least one surface acoustic wave (SAW) filter and one bulk acoustic wave (BAW) filter, **characterized in that** it comprises the following steps:

   - forming a stack comprising at least one layer of second piezoelectric material (P$_{iézo2}$), a first metallization layer (M$_1$) and a layer of a first monocrystalline piezoelectric material (P$_{iézo1}$) comprising the application of the layer of first piezoelectric material (P$_{iézo1}$) associated with the first metallization layer (M$_1$) on the layer of second piezoelectric material (P$_{iézo2}$);
   - the partial etching of said stack so as to define a first area in which the first and second piezoelectric materials are present and a second area in which the first piezoelectric material and the first metallization layer are absent;
   - producing a second metallization (M$_2$) in the first area to define the bulk acoustic wave filter incorporating the first piezoelectric material and a third metallization (M$_3$) in the second area to define the surface acoustic wave filter incorporating the second piezoelectric material.

2. Method for fabricating an acoustic wave device according to Claim 1, **characterized in that** the application of the layer of first piezoelectric material (P$_{iézo1}$) associated with the first metallization layer (M$_1$) on the layer of second piezoelectric material (P$_{iézo2}$) comprises:

   - defining a thin layer of first piezoelectric material within a substrate of first piezoelectric material comprising a top layer of first metallization defining a first assembly;
   - assembling said first assembly comprising said thin layer of first piezoelectric material defined within a substrate of first piezoelectric material on the first metallization side on the second piezoelectric material;
   - separating said substrate of first piezoelectric material from said thin layer of first piezoelectric material.

3. Method for fabricating an acoustic wave device according to Claim 2, **characterized in that** defining the thin layer of first piezoelectric material comprises the following steps:

   - metallizing a substrate comprising, at least on the surface, the first piezoelectric material;
   - implanting ions in said substrate to create, in the first piezoelectric material, a buried fragile area defining the thin layer of first piezoelectric material.

4. Method for fabricating an acoustic wave device according to Claim 3, **characterized in that** the ion implantation is performed with hydrogen ions and/or helium ions.

5. Method for fabricating an acoustic wave device according to Claim 2, **characterized in that** the separation is produced by heat treatment.

6. Method for fabricating an acoustic wave device according to Claim 1, **characterized in that** the application of the layer of first piezoelectric material (P$_{iézo1}$) associated with the first metallization layer (M$_1$) on the layer of second piezoelectric material (P$_{iézo2}$) comprises:

   - a step of assembling a first substrate comprising at least one layer of first piezoelectric material covered with a top layer of first metallization with a second piezoelectric material and
   - a step of thinning the first substrate by lapping/polishing so as to define a thin layer of first piezoelectric material.

7. Method for fabricating an acoustic wave device according to one of Claims 2 to 6, **characterized in that** assembling is performed by molecular bonding.

8. Method for fabricating an acoustic wave device according to one of Claims 2 to 7, **characterized in that** the first assembly comprises a first bonding layer, the second piezoelectric material being covered with a second bonding layer.

9. Method for fabricating an acoustic wave device according to Claim 8, **characterized in that** the first assembly comprises a decoupling layer.

10. Method for fabricating an acoustic wave device according to one of Claims 1 to 9, **characterized in that** the layer of second piezoelectric material ($P_{iézo2}$) consists of the superficial portion of a bulk substrate of second piezoelectric material.

11. Method for fabricating an acoustic wave device according to one of Claims 1 to 10, **characterized in that** the layer of second piezoelectric material ($_{Piézo2}$) is deposited or applied by epitaxy or applied on a substrate.

12. Method for fabricating an acoustic wave device according to one of Claims 1 to 11, **characterized in that** the second piezoelectric material is of $LiNbO_3$, $LiTaO_3$, $La_3Ga_5SiO_{14}$ (langasite), $La_3Ga_{5.5}Ta_{0.5}O_{14}$ (langatate) type.

13. Method for fabricating an acoustic wave device according to one of Claims 1 to 11, **characterized in that** the second piezoelectric material is of $SrTiO_3$ (STO) or $PbZrTiO_3$ (PZT) or AlN or ZnO type.

14. Method for fabricating an acoustic wave device according to one of Claims 1 to 13, **characterized in that** the first piezoelectric material is of $LiNbO_3$ (LNO), $LiTaO_3$ (LTO), $La_3Ga_5SiO_{14}$ (langasite), $La_3Ga_{5.5}Ta_{0.5}O_{14}$ (langatate), $SrTiO_3$ (STO), $PbZrTiO_3$ (PZT), AlN, ZnO type.

15. Method for fabricating an acoustic wave device according to one of Claims 1 to 14, **characterized in that** the first metal layer is made of metal of copper (Cu), copper and aluminium alloy (AlCu), tungsten (W), molybdenum (Mo), AlSi, Cr type.

16. Method for fabricating an acoustic wave device according to one of Claims 7 to 15, **characterized in that** the molecular bonding is done with a molecular bonding layer inserted between the first metallization and the second piezoelectric material, of low temperature oxide type of $SiO_2$ type.

FIG.1a

FIG.1b

FIG.2

A      B

A

H+

Etape 1    A

Etape 2    ∀        B

Etape 3    B        ∀

Etape 4

# FIG.3

**FIG.4a**

Implantation ionique

**FIG.4b**

**FIG.4c**

$Cc_2$

$C_2$

$Piézo_2$

FIG.4d

$Piézo_1$

$C_{Piézo1}$

$M_1$

$Cc_1$

$Cc_2$

$C_2$

$Piézo_2$

FIG.4e

$C_{Piézo1}$

$M_1$

$Cc_1$

$Cc_2$

$C_2$

$Piézo_2$

FIG.4f

$C_{Piézo1}$

$M_1$

$Cc_1 + Cc_2$

$C_2$

$Piézo_2$

## FIG.4g

$M_2$

$C_{Piézo1}$

$M_1$

$Cc_1 + Cc_2$

$M_3$

$C_2$

$Piézo_2$

## FIG.4h

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 6424238 B
- US 20070057772 A
- US 20080284541 A
- US 2008024245 A

**Littérature non-brevet citée dans la description**

- **K.M. LAKIN ; J.S. WANG.** UHF composite bulk wave resonators. *IEEE Ultrasonics Symposium Proceedings,* 1980, 834-837
- **DE R. AIGNER.** Bringing BAW technology into volume production: the Ten Commandments and the seven deadly sins. *Proceedings of the third international symposium on acoustic wave devices for future mobile communication systems,* 2007
- **J. KAITILA.** Review of wave propagation in BAW thin film devices: progress and prospects. *Proceedings of the 2007 IEEE Ultrasonics Symposium*
- **P. MURAIT et al.** Is there a better material for thin film BAW applications than AlN. *Proceedings of the 2005 IEEE Ultrasonics Symposium,* 2005
- **D. GACHON et al.** Filters using high overtone bulk acoustic resonators on thinned single-crystal piezoelectric layer. *European Frequency and Time Forum,* 2008
- **H.L. SALVO et al.** Shear mode transducers for high Q bulk microwave resonators. *Proceedings of the 41st Annual Frequency Control Symposium,* 1987
- **J.S. WANG et al.** Sputtered c-axis piezoelectric films and shear wave resonators. *Proceedings of the 37th Annual Frequency Control Symposium,* 1983
- **N.LOBO ; D.C.MALOCHA.** Ultrasonics Symposium. School of Electrical Engineering and Computer Science University of Central Florida, 2006
- Silicon on insulator material technology. *Electronic letters,* 1995, vol. 31 (14), 1201-1202
- **L. DICIOCCIO ; F. LETERTRE ; Y. LE TIEC ; A.M. PAPON ; C. JAUSSAUD ; M. BRUEL.** Silicon carbide on insulator formation by Smart Cut™ process. *Master. Sci. Eng.,* 1997, vol. B46, 349-356

- **E. JALAGUIER ; B. ASPAR ; S. POCAS ; J.F. MICHAUD ; M. ZUSSY ; A.M. PAPON ; M. BRUEL.** Transfer of thin GaAs film on silicon substrate by proton implantation process. *Electronic letters,* 1998, vol. 34 (4), 408-409
- **E. JALAGUIER ; B. ASPAR ; S. POCAS ; J.F. MICHAUD ; A.M. PAPON ; M. BRUEL.** Transfer of thin InP film onto silicon substrate by proton implantation process. *IEEE Proc.11th International Conférence on Indium Phosphide and Related Materials,* 1999
- **A. TAUZIN ; T. AKATSU ; M. RABAROT ; J. DECHAMP.** Transfers of 2-inch GaN films onto sapphire substrates using Smart CutTM technology. *Electronics Letters,* 26 Mai 2005, vol. 41 (11
- **C. DEGUET et al.** 200 mm Germanium-On-Insulator (GeOI) structures realized from epitaxial Germanium wafers by the Smart Cut™ technology. Electro Chemical Society, 2005
- **Y.B. PARK ; B. MIN ; J. VAHALA ; H.A. ATWATER.** *Advanced Materials,* 2006, vol. 18, 1533
- Ferroelectric oxide single-crystalline layers by wafer bonding and Hydrogen/Helium implantation. **M. ALEXE.** Mat. Res. Soc. Symp. Proc. 2003, vol. 748
- Investigation of H+ and B+/H+ implantation in LiTa03 single crystals. *Nuclear Instruments and Methods in Physics Research,* 2001, vol. B 184, 53
- **J-S. MOULET.** High piezoelectric properties in LiNbO3 transferred layer by the Smart Cut technology for ultra wide band BAW filter application. *IEDM 2008 - IEEE- International -Electron -Devices -Meeting.-Technical - Digest.,* 2008